Europäisches Patentamt

European Patent Office

Office européen des brevets

(19)

(11) **EP 0 671 791 B1**

(12) **FASCICULE DE BREVET EUROPEEN**

(45) Date de publication et mention
de la délivrance du brevet:
**26.08.1998 Bulletin 1998/35**

(51) Int Cl.⁶: **H01S 3/025**, H04B 10/18,
H04B 10/155, G02F 1/025

(21) Numéro de dépôt: **95400520.3**

(22) Date de dépôt: **10.03.1995**

(54) **Modulateur semiconducteur électro-optique et liaison optique incluant ce modulateur**

Elektrooptischer Halbleitermodulator und optisches Transmissionssystem unter Verwendung dieses Modulators

Semiconductor electrooptical modulator and optical transmission system including this modulator

(84) Etats contractants désignés:
**DE ES FR GB IT NL SE**

(30) Priorité: **11.03.1994 FR 9402858**

(43) Date de publication de la demande:
**13.09.1995 Bulletin 1995/37**

(73) Titulaire: **ALCATEL ALSTHOM COMPAGNIE GENERALE D'ELECTRICITE**
**75008 Paris (FR)**

(72) Inventeurs:
• **Lesterlin, Dominique**
**F-94400 Vitry sur Seine (FR)**
• **Langanay, Jérôme**
**F-92120 Montrouge (FR)**
• **Provost, Jean Guy**
**F-91310 Longpont sur Orge (FR)**

(74) Mandataire: **Sciaux, Edmond et al**
**COMPAGNIE FINANCIERE ALCATEL**
**Dépt. Propr. Industrielle,**
**30, avenue Kléber**
**75116 Paris (FR)**

(56) Documents cités:
• **PATENT ABSTRACTS OF JAPAN vol. 15, no. 209 (E-1072) 28 Mai 1991 & JP-A-03 057 285 (FUJITSU LTD)**
• **IEEE PHOTONICS TECHNOLOGY LETTERS, vol.4, no.12, Décembre 1992, NEW YORK US pages 1394 - 1397 J.C. CARTLEDGE ET AL 'Performance of 10 Gb/s Lightwave systems using an adjustable chirp optical modulator and linear equalization'**
• **IEEE PHOTONICS TECHNOLOGY LETTERS, vol.3, no.1, 1 Janvier 1991, NEW YORK US pages 74 - 76 T. SAITO ET AL 'Prechirp technique for dispersion compensation for a high speed long span transmission'**
• **IEEE PHOTONICS TECHNOLOGY LETTERS, vol.3, no.10, Octobre 1991, NEW YORK US pages 916 - 918 A.H: GNAUCK ET AL 'Dispersion penalty reduction using an optical modulator with adjustable chirp'**
• **PATENT ABSTRACTS OF JAPAN vol. 17, no. 539 (P-1621) 28 Septembre 1993 & JP-A-05 150 198 (NTT)**
• **ELECTRONICS LETTERS., vol.29, no.11, 27 Mai 1993, STEVENAGE, HERTS, GB pages 1002 - 1004 H. TANAKA ET AL 'Optical short pulse generation and data modulation by a single chip InGaAsP tandem integrated electroabsorption modulator'**
• **APPLIED PHYSICS LETTERS., vol.53, no.14, 3 Octobre 1988, NEW YORK US pages 1297 - 1298 S.C: LIN ET AL 'Semiconductor waveguide phase comparator'**

## Description

La présente invention concerne notamment les liaisons à fibres optiques aptes à transmettre des débits d'information importants tels que 10 Gbit/s à $\lambda = 1,5\mu m$.

La réalisation économique d'une telle liaison nécessite l'emploi de fibres optiques du type dit G652 qui présentent une dispersion chromatique nulle à $\lambda = 1,3\mu m$ et qui ont l'avantage d'être relativement peu coûteuses mais aussi l'inconvénient de présenter une dispersion chromatique relativement importante telle que 17 pS/$\mu m$ à $\lambda = 1,55\ \mu m$. Lorsque la liaison présente une longueur supérieure à 100 Km environ cette dispersion chromatique impose aux signaux transmis une distorsion telle que le taux d'erreurs à la réception augmente de manière gênante. Pour limiter cette augmentation du taux d'erreurs il est connu d'appliquer, à des signaux impulsionels portés par une modulation d'amplitude d'une onde optique, une variation de phase optique appelée prédistorsion de phase et réalisée sur chaque impulsion.

Les liaisons optiques connues ne permettent cependant pas de concilier l'emploi de fibres présentant une dispersions chromatique gênante à la longueur d'onde de la liaison telles que les fibres G652, une distance de transmission importante, un débit d'information élevé, et une prédistorsion de phase s'opposant autant qu'il conviendrait à l'augmentation du taux d'erreurs de la liaison résultant de la dispersion chromatique des fibres employées.

La présente invention a notamment pour but de concilier ces divers éléments pour diminuer le taux d'erreurs d'une liaison optique à grand débit d'information.

La demande de brevet Japonais n°3 057 285 décrit un modulateur semi-conducteur électro-optique comportant deux segments successifs constituant respectivement un modulateur à photo-absorption et un déphaseur. Le segment modulateur à photo-absorption présente un défaut : il ne module pas seulement l'amplitude, il module aussi la fréquence de l'onde lumineuse qui le traverse. Pour remédier à ce défaut, le segment déphaseur est commandé de manière à créer un déphasage compensant la modulation de fréquence parasite créée par le segment modulateur à photo-absorption. Il est même possible de dépasser la compensation pour créer à volonté une modulation de fréquence superposée à la modulation d'amplitude. Cependant ce modulateur a pour inconvénient d'être complexe et cher à fabriquer car les deux segments sont constitués de matériaux semi-conducteurs différents. L'invention a pour but de réaliser de manière simple un modulateur permettant de moduler l'amplitude et la phase d'une onde optique à un rythme élevé.

Dans ces buts, elle a notamment pour objet un modulateur semiconducteur électro-optique, comportant un guide de lumière comportant deux segments successifs appliquant chacun à la fois une atténuation et un déphasage à une onde lumineuse, chacun de ces deux segments étant muni d'électrodes de commande reliées à un générateur de commande; chacun de ces deux segments présentant :

- une sensibilité électrique d'atténuation égale au rapport d'une variation du coefficient d'absorption moyen de ce segment à une variation d'une tension de commande ayant entraîné cette variation de ce coefficient,
- et une sensibilité électrique de déphasage égale au rapport de la variation d'un angle de déphasage, à une variation d'une tension de commande,
- la relation entre cette sensibilité électrique d'atténuation et cette sensibilité électrique de déphasage étant exprimée par un facteur $\alpha$ dit de couplage phase-amplitude défini par l'équation :

$$\frac{d\varphi}{dt} = \frac{\alpha}{2} \frac{1}{CA} \frac{dCA}{dt}$$

où t représente le temps, et CA représente le coefficient d'absorption moyen ; ce facteur de couplage étant plus petit dans l'un des segments appelé segment d'atténuation que dans l'autre segment appelé segment de déphasage,

caractérisé en ce que les deux segments ont la même constitution ; et en ce que, pour obtenir un facteur de couplage phase-amplitude $\alpha$ plus petit dans le segment d'atténuation que dans le segment de déphasage, le générateur de commande fournie des composants continues de lesdites tensions de commande différentes respectivement aux électrodes des deux segments.

Il a été trouvé selon cette invention qu'il était possible de choisir, pour les deux segments d'atténuation et de déphasage, des structures semiconductrices et des composantes continues des tensions de commande telles que les composantes alternatives constituées par les deux dites combinaisons différentes appliquent effectivement à l'onde lumineuse une atténuation et un déphasage respectivement égaux à la consigne d'atténuation et à la consigne de déphasage. Un tel choix est autorisé par l'utilisation de structures semiconductrices à puits quantiques multiples.

A l'aide des figures schématiques ci-jointes, on va décrire plus particulièrement ci-après, à titre d'exemple non limitatif, comment la présente invention peut être mise en oeuvre. Lorsqu'un même élément est représenté sur plusieurs figures il y est désigné par le même signe de référence.

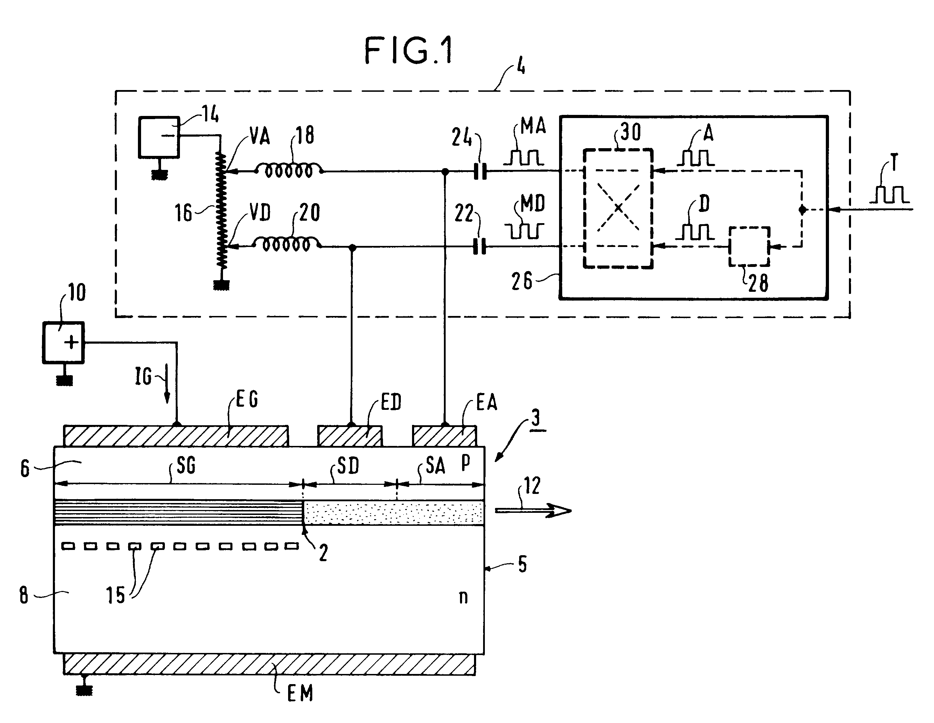

La figure 1 représente une vue d'un modulateur selon cette invention avec coupe longitudinale d'une plaquette semiconductrice de ce modulateur.

La figure 2 représente des diagrammes de variations d'une atténuation et d'un déphasage appliqués à une onde optique par la plaquette de la figure 1, les tensions appliquées à cette plaquette pour réaliser cette atténuation et ce déphasage étant portées en abscisses.

La figure 3 représente une vue d'une liaison optique incluant le modulateur de la figure 1.

La figure 4 illustre le fonctionnement du modulateur selon l'invention, dans cette liaison optique, pour un exemple de signal à transmettre.

Le modulateur semiconducteur électro-optique donné en exemple comporte les élements connus suivants:

- Un guide de lumière 2 apte à guider une onde lumineuse selon une direction longitudinale et à la laisser sortir en extrémité de ce guide sous la forme d'une onde de sortie 12.

  Dans le cas donné en exemple où ce guide est formé dans une plaquette semiconductrice 3 et où son extrémité en question est formée par une face extrême de cette plaquette, cette face extrême est oblique et/ou porte un revêtement antiréfléchissant pour permettre la sortie de l'onde lumineuse. Le guide 2 présente un effet électro-optique apte à moduler l'onde de sortie.

- Des électrodes EA, ED, EM disposées en regard de ce guide.

- Enfin un générateur de commande 4 apte à recevoir un signal d'entrée T et à fournir en réponse à ces électrodes une tension de commande variable créant un champ électrique dans le guide 2 pour moduler l'onde de sortie 12.

Selon la présente invention le guide 2 comporte deux segments s'étendant et se succédant selon la direction longitudinale, à savoir un segment d'atténuation SA et un segment de déphasage SD. Chacun de ces deux segments présente d'une part une sensibilité électrique d'atténuation dCA/dV1 égale au rapport d'une variation dCA du coefficient d'absorption moyen CA de ce segment à une variation dV1 de la tension de commande V1 ayant entraîné cette variation de ce coefficient. Il présente d'autre part une sensibilité électrique de déphasage dφ/dV2 égale au rapport de la variation dφ d'un angle de déphasage φ à une variation dV2 de la tension de commande V2 ayant entraîné cette variation de cet angle. Cet angle φ est fonction de l'indice de réfraction moyen de ce segment.

La relation entre la sensibilité électrique d'atténuation à la sensibilité électrique de déphasage de chaque segment est exprimée par un facteur de couplage phase amplitude α défini par l'équation

$$\frac{d\varphi}{dt} = \frac{\alpha}{2} \frac{1}{CA} \frac{dCA}{dt},$$

t représentant le temps.

Le facteur α est propre à ce segment. Il est plus petit dans le segment d'atténuation SA que dans le segment de déphasage SD.

Lesdites électrodes constituent des électrodes d'atténuation EA et EM disposées en regard du segment d'atténuation SA et des électrodes de déphasage ED et EM disposées en regard du segment de déphasage SD. Elles permettent ainsi d'appliquer à ces deux segments deux tensions de commande différentes constituant respectivement une tension de commande de segment d'atténuation et une tension de commande de segment de déphasage. Chacune de ces tensions a une composante continue et une composante alternative.

Le générateur de commande 4 reçoit un signal d'entrée T définissant d'une part une consigne A représentative d'une variation d'atténuation à appliquer à ladite onde de sortie, d'autre part une consigne D représentative d'une variation de déphasage optique à appliquer à cette onde. Il fournit en réponse la composante alternative de la tension de commande du segment d'atténuation MA sous la forme d'une première combinaison, par exemple, linéaire:

$$MA = k1.A + k2.D$$

la consigne d'atténuation A et la consigne de déphasage D. Il fournit d'autre part la composante alternative de la tension de commande du segment de déphasage MD sous la forme d'une deuxième combinaison:

$$MD = k3.A + k4.D$$

de la consigne d'atténuation A et la consigne de déphasage D. Cette deuxième combinaison est elle, par exemple, linéaire, mais elle est différente de la première. Les coefficients k1, k2, k3 et k4 sont constants. Le rapport k1/k2 est différent du rapport k3/k4.

Le générateur 4 fournit enfin les composantes continues VA, VD des tensions de commande des segments d'atténuation et de déphasage.

Selon une disposition préférée les segments d'atténuation SA et de déphasage SD sont constitués par des structures semiconductrices à puits quantiques multiples. Il a en effet été trouvé, dans le cadre de la présente invention, que de telles structures permettaient d'obtenir que la différence entre les deux facteurs de couplage phase amplitude α1 et α2 des deux segments d'atténuation et de déphasage soit suffisante pour la réalisation pratique et économique d'un modulateur convenant pour une liaison optique à longue distance telle que celle qui sera décrite plus loin. Il doit cependant être compris que d'autres types de structures à effet électro-optique pourraient éventuellement convenir.

Le guide de lumière 2 est typiquement formé dans une plaquette semiconductrice monocristalline 3 entre deux couches de confinement 6, 8 présentant des types de conductivité opposés p et n. Il peut alors avantageusement comporter en outre un segment d'amplification

SG inclus dans une cavité optique résonante et constitué par un matériau apte à devenir optiquement amplificateur sous l'action d'un courant d'injection IG circulant dans un sens direct entre ces deux couches de confinement. Cette cavité résonante est constituée par un réflecteur de Bragg distribué 15 couplé au guide 2.

Des électrodes d'amplification EG et EM sont disposées en regard du segment d'amplification SG et alimentées par une source électrique d'amplification 10 pour faire passer le courant d'injection dans le sens direct entre ces deux couches de confinement. Ce segment d'amplification constitue alors un laser DFB intégré dans le modulateur pour engendrer une onde lumineuse dans le guide 2.

Le générateur de commande 4 fournit les composantes continues VA, VD des tensions de commande des segments d'atténuation et de déphasage de manière à empêcher le passage d'un courant entre les deux couches de confinement 6 et 8. Le passage d'un tel courant est empêché soit si une telle tension de commande a un sens inverse opposé audit sens direct, soit si cette tension a le sens direct mais une valeur inférieure à une limite dépendant des dopages des couches.

Selon une disposition facilitant la réalisation du modulateur les deux segments d'atténuation SA et de déphasage SD présentent des constitutions identiques. Cette identité de constitution leur confère des sensibilités électriques égales lorsqu'ils sont soumis à des tensions de commande variables restant mutuellement égales. Cependant, compte tenu du choix de la structure semiconductrice commune à ces deux segments, ces sensibilités dépendent fortement des composantes continues VA et VD de ces tensions de commande. Le générateur de commande 4 donne alors à ces deux composantes continues VA, VD deux valeurs différentes pour donner au facteur de couplage phase amplitude une valeur sensiblement plus petite dans le segment d'atténuation SA que dans le segment de déphasage SD.

Plus particulièrement les électrodes précédemment mentionnées constituent une électrode commune EM s'étendant sur toute la longueur du guide 2, et des électrodes spécifiques d'atténuation EA, de déphasage ED et d'amplification EG, respectivement.

Les composantes continues VA et VD des tensions de commande des segments d'atténuation et de déphasage sont fournies aux électrodes EA et ED par une source de polarisation continue 14 à travers un diviseur résistif 16 et des inductances de séparation 18 et 20.

Les composantes alternatives MA et MD de ces tensions de commande sont respectivement fournies à ces mêmes électrodes EA et ED, à travers des condensateurs de séparation 22 et 24, par un circuit de modulation 26 recevant un signal d'entrée T définissant directement la consigne d'atténuation A. Ce circuit réalise diverses opérations représentées aux figures par des composants internes symboliques. Un premier tel composant symbolique est un générateur de déphasage 28 qui forme la consigne de déphasage D à partir du signal d'entrée T. Un deuxième tel composant symbolique est un circuit de combinaison 30 qui forme les deux combinaisons linéaires précédemment mentionnées pour constituer ainsi les deux composantes alternatives MA et MD.

En pratique dans un cas simple où le modulateur est utilisé dans une liaison optique qui sera décrite plus loin, ces deux composantes présentent des variations ayant constamment des sens opposés et ayant des amplitudes dans un rapport constant choisi après essais.

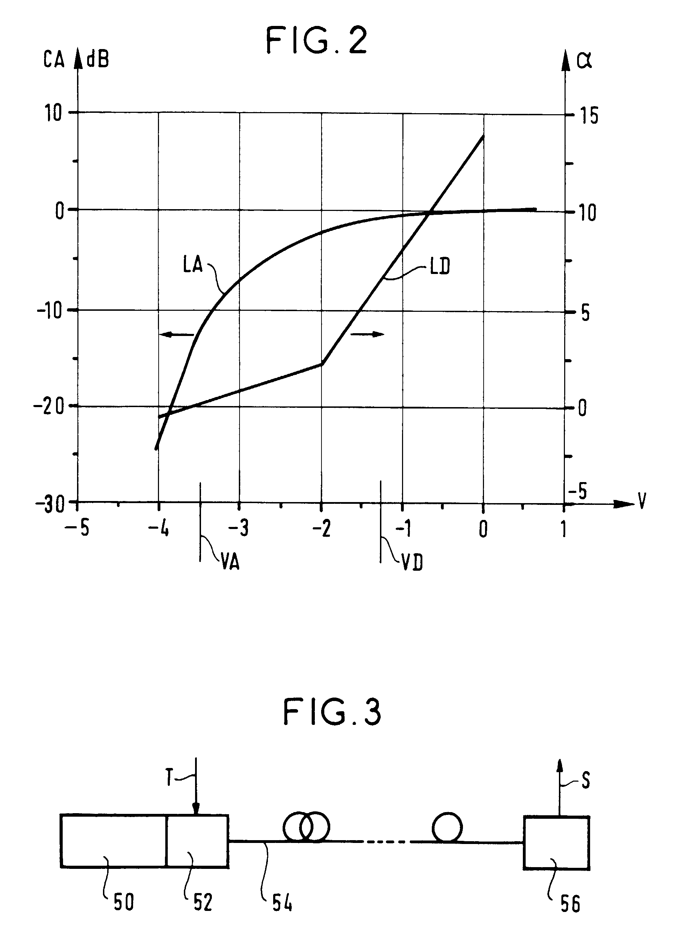

Le choix des composantes continues VA et VD apparaît sur la figure 2 sur laquelle les diagrammes LA et LD représentent respectivement les variations du coefficient d'absorption CA et du facteur de couplage phase-amplitude a, ce facteur définissant le déphasage, en fonction dans chaque cas de la tension appliquée entre l'électrode spécifique correspondante EA ou ED et l'électrode commune EM. Ces tensions sont représentées comme négatives parce qu'elles polarisent en inverse la diode formée par les couches de confinement 6 et 8. La tension VA procure une sensibilité électrique d'atténuation plus grande et une sensibilité électrique de déphasage plus petite que la tension VD.

Ces diagrammes correspondent aux choix précédemment décrits dans un cas où la lumière sélectionnée par le réflecteur de Bragg 15 présentait une longueur d'onde de 1550 nm.

La présente invention a également pour objet une liaison optique comportant les éléments connus suivants:

- Une source de lumière 50 pour émettre une onde lumineuse.
- Un moyen de modulation 52 recevant un signal d'entrée T porteur d'une information à transmettre et modulant cette onde lumineuse en amplitude en réponse à ce signal.
- Une ligne de transmission à fibre optique 54 recevant et guidant cette onde lumineuse modulée tout en présentant une dispersion chromatique propre à provoquer une distorsion de cette onde.
- Enfin un récepteur 56 recevant cette onde en sortie de cette liaison et fournissant en réponse un signal de sortie S, ce signal de sortie restituant l'information à transmettre avec un taux d'erreurs accru par distorsion de la ligne 54.

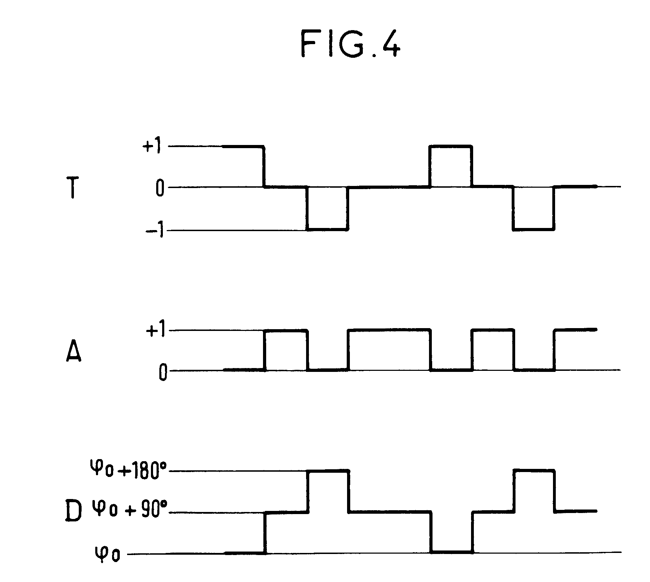

Selon la présente invention la source de lumière 50 et le moyen de modulation 52 sont respectivement constitués par le segment d'amplification SG et par l'ensemble des segments d'atténuation SA et de déphasage SD du modulateur précédemment décrit. La consigne d'atténuation A est directement définie par le signal à transmettre T. Le générateur de commande élabore la consigne de déphasage D à partir du signal à transmettre T de manière à appliquer à l'onde lumineuse sortant du modulateur un déphasage de prédistorsion compensant par avance au moins partiellement la dispersion chromatique de la ligne. Ce déphasage est choisi pour diminuer autant que possible le taux d'erreur. Dans un exemple d'application, illustré par le chronogramme représenté sur la figure 4, le signal à transmettre T est un signal duo-binaire pouvant prendre les valeurs - 1, 0, + 1. Le générateur 26 élabore une consigne d'atténuation A en prenant directement la valeur absolue du signal T puis en la complémentant à 1 modulo 2, pour avoir une atténuation minimale quand T = ± 1, et une atténuation maximale quand T = 0. Le générateur 28 élabore une consigne de déphasage D commandant un déphasage de prédistorsion égal à $\varphi_0$ + 180° quand T = +1, $\varphi_0$ + 90° quand T = 0, et $\varphi_0$ quand T = - 1, où $\varphi_0$ est une valeur de déphasage fixée et quelconque. Grâce au choix de D = $\varphi_0$ + 90° pour T = 0, dans cet exemple, le signal de valeur D est déduit du signal T très facilement par une simple inversion. La réalisation du générateur 28 est donc très simple.

Il est à remarquer cependant qu'on peut choisir une valeur D quelconque pour T = -1 puisque l'atténuation étant maximale, le signal optique est pratiquement nul pendant les intervalles de temps où T = 0

## Revendications

1.  Modulateur semi-conducteur électro-optique, comportant un guide de lumière (5) comportant deux segments successifs (SA, SD) appliquant chacun à la fois une atténuation et un déphasage à une onde lumineuse (12), chacun de ces deux segments étant muni d'électrodes de commande (EA, EM ; (ED, EM) reliées à un générateur de commande (4) ; chacun de ces deux segments présentant :

    -   une sensibilité électrique d'atténuation (dCA/dV1) égale au rapport d'une variation (dCA) du coefficient d'absorption moyen (CA) de ce segment à une variation (dV1) d'une tension de commande (V1) ayant entraîné cette variation de ce coefficient,
    -   et une sensibilité électrique de déphasage (d$\varphi$/dV2) égale au rapport de la variation (d$\varphi$) d'un angle de déphasage ($\varphi$), à une variation (dV2) d'une tension de commande,
    -   la relation entre cette sensibilité électrique d'atténuation et cette sensibilité électrique de déphasage étant exprimée par un facteur $\alpha$ dit de couplage phase-amplitude défini par l'équation :

    $$\frac{d\varphi}{dt} = \frac{\alpha}{2} \frac{1}{CA} \frac{dCA}{dt}$$

    où t représente le temps, et CA représente le coefficient d'absorption moyen ; ce facteur de couplage étant plus petit dans l'un des segments (SA) appelé segment d'atténuation (SA) que dans l'autre segment (SD) appelé segment de déphasage (SD),

caractérisé en ce que les deux segments (SA, SD) ont la même constitution ; et en ce que, pour obtenir un facteur de couplage phase-amplitude $\alpha$ plus petit dans le segment d'atténuation (SA) que dans le segment de déphasage (SD), le générateur de commande (4) fournit des composants continues (VA, VD) de lesdites tensions de commande différentes respectivement aux électrodes des deux segments.

2.  Modulateur selon la revendication 1, caractérisé par le fait que lesdits segments d'atténuation (SA) et de déphasage (SD) sont constitués par des structures semiconductrices à puits quantiques multiples.

3.  Modulateur selon la revendication 1, caractérisé par le fait que ledit dit guide de lumière (2) est formé dans une plaquette semiconductrice monocristalline (3) entre deux couches de confinement (6, 8) présentant des types de conductivité opposés (n, p),

    ce guide comportant en outre un segment d'amplification (SG) inclus dans une cavité optique résonante et constitué par un matériau apte à devenir optiquement amplificateur sous l'action d'un courant d'injection (IG) circulant dans un sens direct entre ces deux couches de confinement,
    ce modulateur comportant en outre des électrodes d'amplification (EG, EM) disposées en regard de ce segment d'amplification et une source électrique d'amplification (10) alimentant ces électrodes d'amplification pour faire passer ledit courant d'injection dans ledit sens direct entre ces deux couches de confinement de manière à engendrer une onde lumineuse dans ce guide, ledit générateur de commande (4) fournissant lesdites composantes continues (VA, VD) des tensions de commande des segments d'atténuation et de déphasage avec des valeurs empêchant le passage d'un courant entre les deux dites couches de confinement (6, 8).

4.  Modulateur selon la revendication 3, caractérisé par le fait que ladite cavité résonante est constituée par un réflecteur de Bragg distribué (15) couplé audit guide (2) dans ledit segment d'amplification (SG) de sorte que ce segment constitue un laser DFB intégré dans ledit modulateur.

5.  Modulateur selon la revendication 1, caractérisé en ce que le générateur de commande (4) fournit en outre deux composantes alternatives différentes, respectivement aux électrodes (EA, EM ; ED, EM) du segment d'atténuation et du segment de déphasage, sous la forme de deux combinaisons linéaires différentes (k1.A + k2.D . k3.A + K4.D) de ladite consigne (A) d'atténuation, et de ladite consigne (D) de déphasage .

6. Liaison optique comportant:

- une source de lumière (50) pour émettre une onde lumineuse,
- un moyen de modulation (52) recevant un signal d'entrée (T) porteur d'une information à transmettre et modulant cette onde lumineuse en amplitude en réponse à ce signal,
- une ligne de transmission à fibre optique (54) recevant et guidant cette onde lumineuse modulée tout en présentant une dispersion chromatique propre à provoquer une distorsion de cette onde,
- et un récepteur (56) recevant cette onde en sortie de cette liaison et fournissant en réponse un signal de sortie (S), ce signal de sortie restituant ladite information à transmettre avec un taux d'erreurs accru par ladite distorsion;

caractérisée par le fait que ladite source de lumière (50) et ledit moyen de modulation (52) sont respectivement constitués par ledit segment d'amplification (SG) et par l'ensemble desdits segments d'atténuation (SA) et de déphasage (SD) du modulateur selon la revendication 3, ladite consigne d'atténuation (A) étant directement définie par ledit signal à transmettre ;

et en ce que ledit générateur de commande (4) élabore ladite consigne de déphasage(D) à partir dudit signal à transmettre (T) de manière à appliquer à ladite onde lumineuse un déphasage de prédistorsion compensant par avance au moins partiellement ladite dispersion chromatique de la ligne pour diminuer ledit taux d'erreur.

7. Liaison optique selon la revendication 6, caractérisée en ce que pour transmettre un signal (T) qui est un signal duo-binaire pouvant prendre les valeurs -1, 0, + 1, ledit générateur de commande (26) comporte des moyens pour fournir une consigne d'atténuation (A) déduite du signal à transmettre (T) en complémentant la valeur absolue de ce signal à transmettre (T); et des moyens (28) pour fournir une consigne de déphasage (D) commandant : un déphasage $\varphi_0 + 180°$ pour un signal à transmettre (T) égal à - 1, un déphasage quelconque pour un signal à transmettre (T) égal à 0, et un déphasage $\varphi_0 + 0°$

pour un signal à transmettre (T) égal à + 1, où $\varphi_0$ est une valeur de déphasage fixée quelconque.

**Patentansprüche**

1. Elektrooptischer Halbleitermodulator, der einen Lichtleiter (5) aufweist, der zwei aufeinanderfolgende Segmente (SA, SD) aufweist, die jeweils gleichzeitig eine Schwächung und eine Phasenverschiebung auf eine Lichtwelle (12) anwenden, wobei jedes dieser beiden Segmente mit Steuerelektroden (EA, EM; ED, EM) versehen ist, die mit einem Steuergenerator (4) verbunden sind; wobei jedes dieser beiden Segmente aufweist:

- eine elektrische Schwächungsempfindlichkeit (dCA/dV1), die gleich dem Verhältnis einer Änderung (dCA) des mittleren Absorptionskoeffizienten (CA) dieses Segments zu einer Änderung (dV1) einer Steuerspannung (V1) ist, die diese Änderung dieses Koeffizienten bewirkt hat,
- und eine elektrische Phasenverschiebungsempfindlichkeit (dφ/dV2), die gleich dem Verhältnis der Änderung (dφ) eines Phasenverschiebungswinkels (φ) zu einer Änderung (dV2) einer Steuerspannung ist,
- wobei die Beziehung zwischen dieser elektrischen Schwächungsempfindlichkeit und dieser elektrischen Phasenverschiebungsempfindlichkeit durch einen Faktor α, Phasen-Amplituden-Kopplungsfaktor genannt, ausgedrückt wird, der durch die Gleichung:

$$\frac{d\varphi}{dt} = \frac{\alpha}{2} \frac{1}{CA} \frac{dCA}{dt}$$

definiert ist, in der t die Zeit darstellt und CA den mittleren Absorptionskoeffizienten darstellt; wobei dieser Kopplungsfaktor in dem einen (SA) der Segmente, Schwächungssegment (SA) genannt, kleiner als im anderen Segment (SD), Phasenverschiebungssegment (SD) genannt, ist,

dadurch gekennzeichnet, daß die beiden Segmente (SA, SD) die gleiche Anordnung haben, und daß zum Erhalten eines Phasen-Amplituden-Kopplungsfaktors α, der im Schwächungssegment (SA) kleiner als im Phasenverschiebungssegment (SD) ist, der Steuergenerator (4) Gleichspannungskomponenten (VA, VD) der verschiedenen Steuerspannungen entsprechend an die Elektroden der beiden Segmente liefert.

2. Modulator nach Anspruch 1, dadurch gekennzeichnet, daß die Schwächungs- (SA) und Phasenverschiebungssegmente (SD) aus Halbleiteraufbauten mit mehrfachen Quantentöpfen bestehen.

3. Modulator nach Anspruch 1, dadurch gekennzeichnet, daß der Lichtleiter (2) in einer monokristallinen Halbleiterscheibe (3) zwischen zwei Einschlußschichten (6, 8) ausgebildet ist, die entgegengesetzte Leitungstypen (n, p) aufweisen,

wobei dieser Leiter außerdem ein Verstärkungssegment (SG) aufweist, das in einem optischen Resonanzraum eingeschlossen ist und aus einem Material besteht, das geeignet ist, unter Einwirkung eines Injektionsstroms (IG), der in direkter Richtung zwischen diesen beiden Einschlußschichten fließt, optisch verstärkend zu werden,
wobei dieser Modulator außerdem Elektroden (EG, EM) für die Verstärkung, die diesem Verstärkungssegment gegenüber angeordnet sind, und eine Stromquelle (10) für die Verstärkung aufweist, die diese Elektroden für die Verstärkung versorgen, um den Injektionsstrom in der direkten Richtung zwischen diesen beiden Einschlußschichten fließen zu lassen, so daß eine Lichtwelle in diesem Leiter erzeugt wird, wobei der Steuergenerator (4) die Gleichspannungskomponenten (VA, VD) der Steuerspannungen der Schwächungs- und Phasenverschiebungssegmente mit Werten liefert, die den Fluß eines Stromes zwischen den beiden Einschlußschichten (6, 8) verhindern.

4. Modulator nach Anspruch 3, dadurch gekennzeichnet, daß der Resonanzraum von einem verteilten Bragg-Reflektor (15) gebildet wird, der mit dem Leiter (2) im Verstärkungssegment (SG) gekoppelt ist, so daß dieses Segment einen in den Modulator integrierten DFB-Laser bildet.

5. Modulator nach Anspruch 1, dadurch gekennzeichnet, daß der Steuergenerator (4) außerdem zwei verschiedene Wechselspannungskomponenten entsprechend an die Elektroden (EA, EM; ED, EM) des Schwächungssemgents und des Phasenverschiebungssegments in Form von zwei verschiedenen linearen Kombinationen (k1.A + k2.D . k3.A + k4.D) des Einstellwertes (A) der Schwächung und des Einstellwertes (D) der Phasenverschiebung liefert.

6. Optische Verbindung, die aufweist:

- eine Lichtquelle (50) zur Emission einer Lichtwelle,
- ein Modulationsmittel (52), das ein Eingangssignal (T) empfängt, das eine zu übertragende Information trägt, und diese Lichtwelle in Antwort auf dieses Signal in der Amplitude moduliert,
- eine Übertragungsleitung (54) mit Lichtleitfasern, die diese modulierte Lichtwelle empfängt und leitet, wobei sie eine chromatische Dispersion aufweist, die geeignet ist, eine Verzerrung dieser Welle hervorzurufen,
- und einen Empfänger (56), der diese Welle am Ausgang dieser Verbindung empfängt und in Antwort darauf ein Ausgangssignal (S) liefert, wobei dieses Ausgangssignal die zu übertragende Information mit einer durch die Verzerrung erhöhten Fehlerhäufigkeit rekonstruiert,

dadurch gekennzeichnet, daß die Lichtquelle (50) und das Modulationsmittel (52) aus dem Verstärkungssegment (SG) bzw. dem Aufbau aus den Schwächungs- (SA) und Phasenverstärkungssegmenten (SD) des Modulators nach Anspruch 3 besteht, wobei der Einstellwert (A) der Schwächung direkt durch das zu übertragende Signal definiert ist, und daß der Steuergenerator (4) den Einstellwert (D) der Phasenverschiebung ausgehend vom zu übertragenden Signal (T) ausarbeitet, um auf die Lichtwelle eine Vorverzerrungsphasenverschiebung anzuwenden, die die chromatische Dispersion der Leitung im voraus wenigstens teilweise ausgleicht, um die Fehlerhäufigkeit zu verringern.

7. Optische Verbindung nach Anspruch 6, dadurch gekennzeichnet, daß zur Übertragung eines Signals (T), das ein duobinäres Signal ist, das die Werte -1, 0, +1 annehmen kann, der Steuergenerator (26) Mittel zum Liefern eines Einstellwertes (A) der Schwächung des zu übertragenden Signals (T) unter Ergänzung des Absolutwertes dieses zu übertragenden Signals (T) ; und Mittel (28) zum Liefern eines Einstellwertes (D) der Phasenverschiebung aufweist, die steuern: eine Phasenverschiebung $\varphi_0+180°$ für ein zu übertragendes Signal (T) gleich -1, irgendeine Phasenverschiebung für ein zu übertragendes Signal (T) gleich 0 und eine Phasenverschiebung $\varphi_0+0°$ für ein zu übertragendes Signal (T) gleich +1, wobei $\varphi_0$ irgendein fester Phasenverschiebungswert ist.

**Claims**

1. An electro-optical semiconductor modulator including a light guide (5) that includes two successive segments (SA, SD), each of which applies both attenuation and a phase shift to a light wave (12). each of the two segments being provided with control electrodes (EA, EM; ED, EM) connected to a control generator (4); each of the two segments having:

an attenuation response to electricity (dCA/dV1) equal to the ratio of a variation (dCA) in the mean absorption coefficient (CA) of the segment over a variation (dV1) in a control voltage (V1) that caused the variation in the coefficient; and

a phase-shift response to electricity (d$\phi$/dV2) equal to the ratio of the variation (d$\phi$) of a phase-shift angle ($\phi$) over a variation (dV2) in a control voltage;

the relationship between the attenuation response to electricity and the phase-shift response to electricity being expressed by a "phase-amplitude coupling" factor $\alpha$ defined by the following equation:

$$\frac{d\phi}{dt} = \frac{\alpha}{2} \frac{1}{CA} \frac{dCA}{dt}$$

where $t$ represents time, and CA represents the mean absorption coefficient;

the coupling factor being smaller in an "attenuation" one of the segments (SA) than in a "phase-shift" one of the segments (SD);

said modulator being characterized in that the two segments (SA, SD) have the same structure, and in that, to obtain a smaller phase-amplitude coupling factor $\alpha$ in the attenuation segment (SA) than in the phase-shift segment (SD), the control generator (4) supplies the DC components (VA, VD) of said different control voltages to the respective electrodes of the two segments.

2. A modulator according to claim 1, characterized by the fact that said attenuation segment (SA) and said phase-shift segment (SD) are constituted by semiconductor structures having multiple quantum wells.

3. A modulator according to claim 1, characterized by the fact that said light guide (2) is formed in a single-crystal semiconductor chip (3) between two confinement layers (6, 8) having opposite conductivity types (n, p);

the guide further including an amplification segment (SG) included in a resonant optical cavity and constituted by a material capable of becoming optically amplifying under the action of an injection current (IG) flowing in a forward direction between the two confinement layers;

the modulator further including amplification electrodes (EG, EM) disposed facing the amplification segment and an electrical amplification source (10) powering the amplification electrodes so as to cause said injection current to pass in said forward direction between the two confinement layers, thereby generating a light wave in the guide, said control generator (4) supplying said DC components (VA, VD) of the attenuation segment control voltage and of the phase-shift segment control voltage with values that prevent current from passing between said confinement layers (6, 8).

4. A modulator according to claim 3, characterized by the fact that said resonant cavity is constituted by a distributed Bragg reflector (15) coupled to said guide (2) in said amplification segment (SG) so that said amplification segment constitutes a DFB laser integrated in said modulator.

5. A modulator according to claim 1, characterized in that the control generator (4) further supplies two different AC components to the respective electrodes (EA, EM; ED, EM) of the attenuation segment and of the phase-shift segment, in the form of two different linear combinations (k1.A + k2.D: k3.A + k4.D) of said reference attenuation (A), and of said reference phase shift (D).

6. An optical link including:

a light source (50) for emitting a light wave;
modulation means (52) receiving an input signal (T) carrying data to be transmitted, and modulating the amplitude of the light wave in response to the signal;
an optical fiber transmission line (54) receiving and guiding the modulated light wave while having chromatic dispersion suitable for causing distortion in said wave; and
a receiver (56) receiving said wave at the output of the link and responding by supplying an output signal (S), the output signal restoring said data with an error rate that is increased by said distortion;
said link being characterized by the fact that said light source (50) and said modulation means (52) are respectively constituted by said amplification segment (SG) and by the set of said attenuation and phase-shift segments (SA and SD) of the modulator according to claim 3, said reference attenuation (A) being defined directly by said signal to be transmitted;
and by the fact that said control generator develops said reference phase shift (D) on the basis of said signal to be transmitted (T) so as to apply a pre-distortion phase shift to said light wave pre-compensating said chromatic dispersion of the line at least in part so as to reduce said error rate.

7. An optical link according to claim 6, characterized in that, to transmit a signal (T) which is a duo-binary signal that can take the values -1, 0, or +1, said control generator (26) includes means for supplying a reference attenuation (A) derived from the signal to be transmitted (T) by complementing the absolute value of the signal to be transmitted (T); and means (28) for supplying a reference phase shift (D) causing: a phase shift $\phi_0+180°$ for a signal to be transmitted (T) equal to -1, an arbitrary phase shift for a signal to be transmitted (T) equal to 0, and a phase shift $\phi_0 + 0°$ for a signal to be transmitted (T) equal to +1, where $\phi_0$ is an arbitrary fixed phase-shift value.

FIG.1

# FIG. 2

# FIG. 3

# FIG.4